Europäisches Patentamt

European Patent Office

Office européen des brevets

(11) Publication number: **0 058 724**
**B1**

(12) **EUROPEAN PATENT SPECIFICATION**

(45) Date of publication of patent specification: **03.07.85**

(21) Application number: **81902371.4**

(22) Date of filing: **25.08.81**

(86) International application number:
**PCT/JP81/00188**

(87) International publication number:
**WO 82/00739 04.03.82 Gazette 82/07**

(51) Int. Cl.⁴: **H 03 F 3/217, H 03 K 7/08**

(54) **POWER AMPLIFIER.**

(30) Priority: **27.08.80 JP 118200/80**

(43) Date of publication of application:
**01.09.82 Bulletin 82/35**

(45) Publication of the grant of the patent:
**03.07.85 Bulletin 85/27**

(84) Designated Contracting States:
**DE FR GB NL**

(56) References cited:
**CH-A- 482 353**
**FR-A-1 559 477**
**JP-A-52 084 945**
**JP-U-55 100 323**

**WIRELESS WORLD, vol. 72, no. 3, March 1966 HAYWARDS HEATH (GB) M. BRONZITE: "Voltage-Controlled Amplifier-1", pages 106-110**

(73) Proprietor: **SONY CORPORATION**
**7-35 Kitashinagawa 6-Chome Shinagawa-ku Tokyo 141 (JP)**

(72) Inventor: **KOIZUMI, Akio**
**536-1-1-606, Hazama-cho 2-chome Funabashi-shi**
**Chibaken 274 (JP)**
Inventor: **YAMAGISHI, Kiroshi**
**1-27-28, Takaidonishi Suginami-ku Tokyo 168 (JP)**

(74) Representative: **Thomas, Christopher Hugo et al**
**D Young & Co 10 Staple Inn London WC1V 7RD (GB)**

Courier Press, Leamington Spa, England.

## Description

This invention relates to power amplifiers for generating a pulse width modulated (PWM) signal proportional to the amplitude of an input signal.

A known type of power amplifier for this purpose is a so-called class D amplifier. Since such a class D amplifier generally has a transistor in its output stage operating in a switching mode, the output transistor produces relatively little heat and hence the power amplifier can be made small while still producing a large output. Because the efficiency increases as the switching frequency becomes higher, the switching transistor is usually a field effect transistor, which can operate at high speed; unlike a bipolar transistor, the switching speed of which is limited by carrier concentration effect. However, a field effect transistor for use in a power amplifier is more expensive than a bipolar transistor.

Swiss patent specification CH—A—482 353 discloses additional amplitude modulation of a PWM signal in a pulse width modulation low-frequency amplifier in a high-frequency transmitter.

One object of the present invention is to provide a power amplifier in which these defects can be alleviated.

Another object of the present invention is to provide a power amplifier utilizing bipolar transistors in its power amplifying stage.

According to the present invention there is provided a power amplifier for generating a pulse width modulated signal proportional to the amplitude of an input signal, characterised by:

a pair of level-shifting means, each supplied with said input signal;

a pair of switching means controlled by a pulse width modulated signal derived from said input signal for switching output signals from said pair of level-shifting means;

an adding means for combining respective outputs of said pair of switching means to produce a pulse width modulated signal amplitude-modulated in accordance with the level of said input signal; and

a power amplifier stage which is supplied with said output signal of said adding means, said power amplifier stage comprising a pair of bipolar transistors connected in complementary push-pull configuration.

The invention will now be described by way of example with reference to the accompanying drawings, throughout which like parts are referred to by like references, and in which:

Figure 1 is a circuit diagram of an example of a known power amplifier of pulse width modulation type;

Figures 2 to 4 are characteristic graphs used to explain the operation of the amplifier of Figure 1;

Figure 5 is a circuit diagram of an embodiment of power amplifier according to the present invention;

Figure 6 shows signal waveforms used to explain the operation of the amplifier of Figures 1 and 5; and

Figures 7 and 8 are characteristic graphs used to explain the operation of the amplifier of Figure 5.

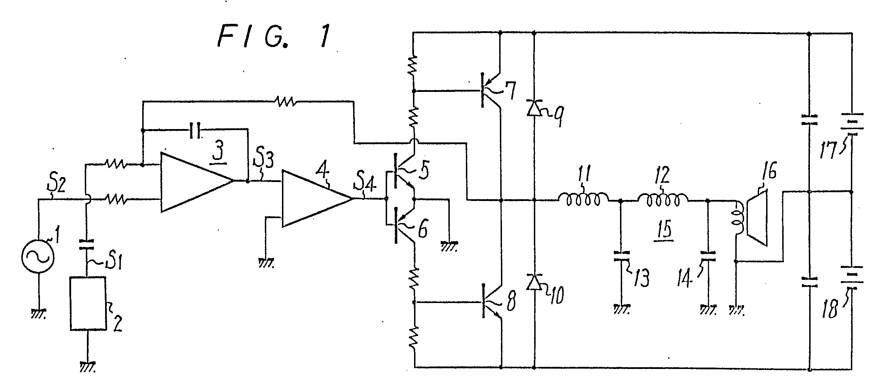

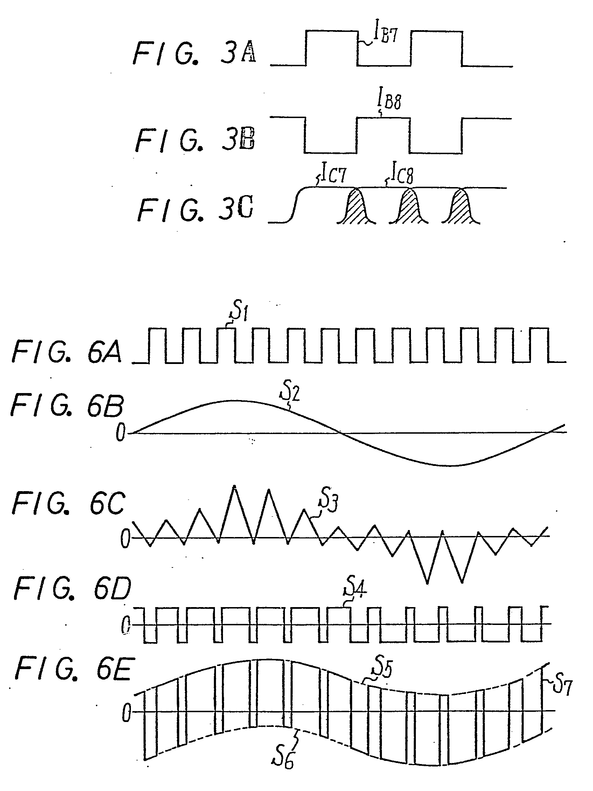

Before describing the embodiment, a known power amplifier of similar type but having a transistor of emitter-grounded saturation type in the output stage will be described with reference to Figure 1. An input signal source 1 generates an input signal $S_2$, the waveform of which is nearly a sine wave as shown in Figure 6B, a reference signal source 2 generates a clock signal $S_1$, the waveform of which is shown in Figure 6A, an integrator 3 integrates the input signal $S_2$ on the basis of the clock signal $S_1$ so as to produce a saw-tooth wave signal $S_3$, the waveform of which is illustrated in Figure 6C, and a comparator 4 compares the saw-tooth wave signal $S_3$ with a reference level (zero level) so as to produce a PWM signal $S_4$ shown in Figure 6D.

Bipolar transistors 5 to 8 form a voltage amplifying section in which diodes 9 and 10 for use in absorbing charges are respectively connected in parllel with the emitter-collector paths of the transistors 7 and 8 in the output stage. If the transistors 7 and 8 are non-saturation type transistors, the diodes 9 and 10 are each connected to their base-collector paths. The output signals of the transistors 7 and 8 are supplied through a filter 15, which comprises coils 11 and 12 and capacitors 13 and 14, to a loudspeaker 16. DC voltage supply sources 17 and 18 are also provided.

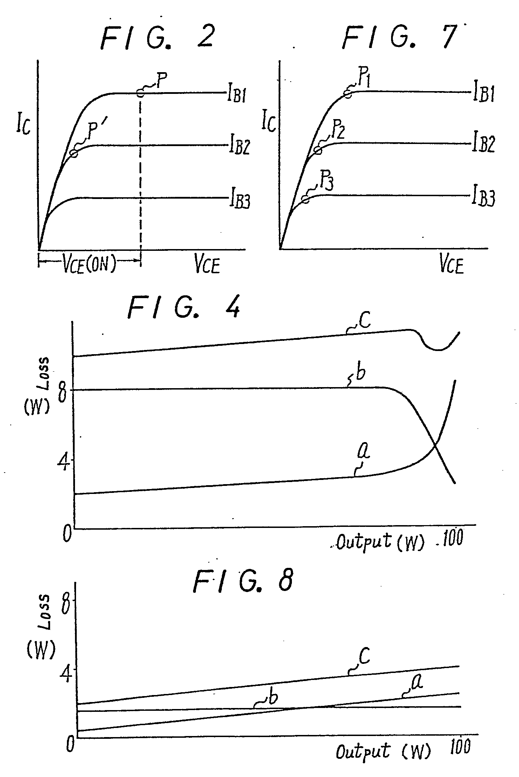

In the case of a power amplifier in which the transistors in the output stage are each of the emitter-grounded saturation type, $V_{CE(ON)}$ is low and hence high efficiency can be expected. Nevertheless, since an operating point P at that time is in the saturated region as illustrated in Figure 2, even if the current which will be supplied to the bases of the transistors 7 and 8 ceases, charges still remain in the transistors 7 and 8. As a result, the collector currents do not cease immediately, and the current flows from the emitter-collector path of the transistor 7 to the collector-emitter path of the transistor 8, which causes the power amplifying efficiency to be deteriorated. Figures 3A to 3C show that when the transistors 7 and 8 are supplied with base currents $I_{B7}$ and $I_{B8}$ as shown in Figures 3A and 3B, respectively, collector currents $I_{C7}$ and $I_{C8}$ respectively flow as shown in Figure 3C. Generally, when the base currents $I_{B7}$ and $I_{B8}$ do not flow, it would be expected that the collector currents $I_{C7}$ and $I_{C8}$ would also not flow nearly simultaneously. But, when the charges remain as described above, then as indicated by hatching in Figure 3C, intervals exist during which the collector currents $I_{C7}$ and $I_{C8}$ flow such that they are superimposed on each other, and these currents flow from the transistor 7 to the transistor 8, which is why the power amplifying efficiency is deteriorated.

The main reason for this is that when an optimum bias is set to widen the effective dynamic range, the base current is selected in consideration of the collector current $I_C$ (max) for a large output, so that in the case of a moderate output, there is too much base current and hence it takes a long time to absorb the charges accumulated therein. For example, as shown in Figure 2, although the operating point in the case of a moderate output stays at the position denoted by P', which is immediately before the beginning of the saturated region, in the case of a large output, the operating point stays at the position denoted by P, which is far into the saturated region. In this case, since the base current $I_{B1}$ at the operating point P is selected as the optimum bias setting and then held fixed, in the case of a moderate output, instead of the original base current $I_{B2}$ being sufficient, excessive base currents corresponding to the difference between the base currents $I_{B1}$ and $I_{B2}$ flow, so that it takes some time to absorb the accumulated charges.

Figure 4 is a graph showing an output-loss characteristic of the known power amplifier operating as described above. In Figure 4, curve $a$ is a characteristic which expresses a loss caused by $V_{CE(ON)}$, curve $b$ is a characteristic showing a loss caused by the switching speed, and curve $c$ is a characteristic showing a summation of the above two losses.

As described above, in the case of the known power amplifier, since the base current is fixed and the position of $V_{CE(ON)}$ is within the saturated region, it takes some time to absorb the accumulated charges and then, as described with reference to Figure 3, the current flows from the transistor 7 to the transistor 8, so that the efficiency is deteriorated and, as will be understood from Figure 4, the loss at that time becomes extremely large.

The embodiment of power amplifier according to the present invention will now be described with reference to Figures 5 to 8.

In this embodiment, there are provided a positive level-shifting circuit 21 and a negative level-shifting circuit 22, each serving for level-shifting the input signal $S_2$, which is supplied from the input signal source 1, towards the positive and negative sides. At the output sides thereof are produced signals $S_5$ and $S_6$, which are respectively shown by broken lines in Figure 6E. The signals $S_5$ and $S_6$ thus derived are supplied through switching circuits 23 and 24 whose opening and closing operations are controlled by a PWM signal $S_4$ supplied from a comparator 4, to an adder 25 which produces at its output a signal $S_7$ shown by a solid line in Figure 6E. In other words, at the output side of the adder 25 is produced the PWM signal $S_4$ which is amplitude-modulated by the signals $S_5$ and $S_6$, each being level-shifted to the positive and negative sides.

The PWM signal $S_7$ thus amplitude-modulated is supplied through a buffer circuit 26 to the bases of the transistors 5 and 6. Otherwise the arrangement is the same as in Figure 1.

The operation of the embodiment will now be described. When the input signal source 1 produces the input signal $S_2$ as shown in Figure 6B, the input signal $S_2$ is integrated by an integrator 3 on the basis of the clock signal $S_1$ which is supplied from the reference signal source 2 and is shown in Figure 6A, and is then converted to the saw-tooth wave signal $S_3$ shown in Figure 6C. This saw-tooth wave signal $S_3$ is supplied to the comparator 4 in which it is compared with the reference level. Thus, the comparator 4 produces at its output side the PWM signal $S_4$ shown in Figure 6D.

On the other hand, the input signal $S_2$ from the input signal source 1 is also supplied to the level-shifting circuits 21 and 22 in which it is level-shifted respectively to the positive and negative sides. Accordingly, the level shifting circuits 21 and 22 produce at their outputs the signals $S_5$ and $S_6$, respectively, shown by the broken lines in Figure 6E, which are then supplied to the corresponding switching circuits 23 and 24. The switching circuits 23 and 24 are controlled to open and close by the PWM signal $S_4$ obtained at the output side of the comparator 4, so that they selectively produce the signal $S_5$ or $S_6$ applied thereto. More specifically, when the PWM signal $S_4$ is positive, the switching circuit 23 is closed to produce the signal $S_5$ shifted in level to the positive side, while when the PWM signal $S_4$ is negative, the switching circuit 24 is closed to produce the signal $S_6$ shifted in level to the negative side. The signals so derived are supplied in turn to the adder 25, and the adder 25 produces at its output the signal $S_7$ shown by the full line in Figure 6E, that is, the amplitude-modulated PWM signal $S_7$.

The PWM signal $S_7$ controls the transistors 5 and 6, by which the corresponding base currents are supplied to the transistors 7 and 8 at the final stage. The base current $I_B$ with which the transistors 7 and 8 operate in the saturated state is set as in the following equation, where the collector current and the current amplification factor of the transistors 7 and 8 are respectively taken as $I_c$ and $h_{FE}$.

$I_B$ is approximately equal to (1.5 to 3)

$$\frac{I_c}{h_{FE}} \qquad (1)$$

That is, the base current of the transistors 7 and 8 is varied by the signal $S_7$, which is provided by amplitude-modulating the PWM signal $S_4$ with the input signal $S_2$, so as always to satisfy equation (1).

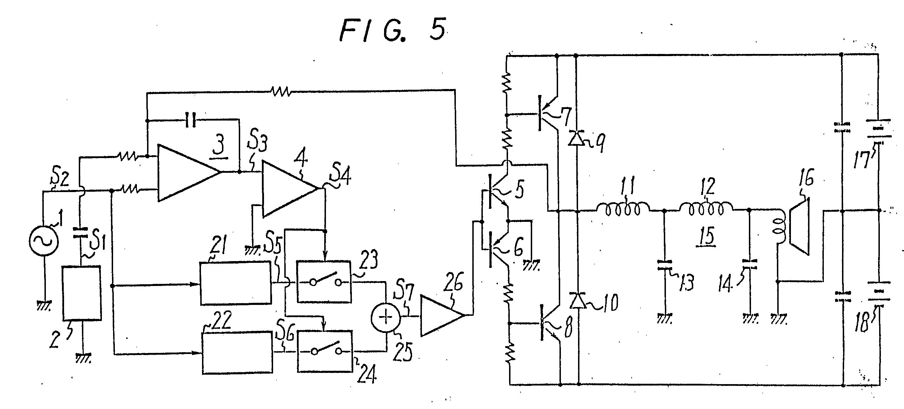

At this time, the operating points $P_1$ to $P_3$ of the transistors 7 and 8 are always immediately before the beginning of the saturation region, in accordance with the increase or decrease of the collector current $I_c$ as shown in Figure 7. In other words, since only the required minimum base currents in response to the respective outputs are supplied to the transistors 7 and 8, when the supply of the base currents ceases, the collector currents no longer flow therethrough, so the phenomenon in the amplifier of Figure 1, that the charges are accumulated in the transistors 7 and 8 and even although the base current ceases, the collector current continues to flow, does not occur.

Figure 8 is a graph showing an output-loss characteristic in the embodiment. Curve *a* represents a characteristic to express a loss caused by $V_{CE(ON)}$, curve *b* represents a characteristic to express a loss caused by a switching speed, and curve *c* represents a characteristic to express a summation characteristic of both of the above losses. Comparing the loss characteristics of Figure 8 with those of the known circuit shown in Figure 4, it is apparent that the output-loss characteristic of the embodiment is substantially improved. In addition, as will be understood from Figure 8, in the embodiment, since the output-loss characteristics change is substantially linear, the distortion factor is improved over the whole range of the output. Thus a power amplifier can be provided which has less losses caused by $V_{CE(ON)}$ or high switching speed, and which is low in distortion and high in efficiency.

## Claims

1. A power amplifier for generating a pulse width modulated signal proportional to the amplitude of an input signal $(S_2)$, characterised by:

a pair of level-shifting means (21, 22), each supplied with said input signal $(S_2)$;

a pair of switching means (23, 24) controlled by a pulse width modulated signal $(S_4)$ derived from said input signal $(S_2)$ for switching output signals $(S_5, S_6)$ from said pair of level-shifting means (21, 22);

an adding means (25) for combining respective outputs $(S_5, S_6)$ of said pair of switching means (23, 24) to produce a pulse width modulated signal $(S_7)$ amplitude-modulated in accordance with the level of said input signal $(S_2)$; and

a power amplifier stage (5 to 10) which is supplied with said output signal $(S_7)$ of said adding means (25), said power amplifier stage (5 to 10) comprising a pair of bipolar transistors (7, 8) connected in complementary push-pull configuration.

2. A power amplifier according to claim 1 wherein said pair of level-shifting means (21, 22) level-shift the level of said input signal $(S_2)$ by predetermined amounts in positive and negative directions, respectively.

3. A power amplifier according to claim 1 further comprising pulse width modulating means (2 to 4) comprising an integrating circuit (3) for integrating said input signal $(S_2)$ in dependence on a clock signal $(S_1)$ supplied by a clock signal source (2) to produce a saw-tooth signal $(S_3)$, and a comparator (4) for comparing the saw-tooth signal $(S_3)$ with a reference voltage, whereby said pulse width modulated signal $(S_4)$ is produced at the output of said comparator (4).

4. A power amplifier according to claim 1, claim 2 or claim 3 wherein a further pair of transistors (5, 6) in said power amplifier stage (5 to 10) are respectively connected in emitter-grounded configuration.

## Patentansprüche

1. Leistungsverstärker zum Erzeugen eines proportional zu der Amplitude eines Eingangssignals $(S_2)$ impulsbreitenmodulierten Signals, gekennzeichnet durch ein Paar von Pegelverschiebungsmitteln (21, 22), die jeweils mit dem Eingangssignal $(S_2)$ versorgt werden;

ein Paar von Schaltmitteln (23, 24), die durch ein impulsbreitenmoduliertes Signal $(S_4)$ gesteuert werden, das aus dem Eingangssignal $(S_2)$ gewonnen wird, zum Schalten von Ausgangssignalen $(S_5, S_6)$ aus dem Paar von Pegelverschiebungsmitteln (21, 22);

ein Addiermittel (25) zum Kombinieren der jeweiligen Ausgangssignale $(S_5, S_6)$ des Paares von Schaltmitteln (23, 24), um ein impulsbreitenmoduliertes Signal $(S_7)$ zu erzeugen, das in Übereinstimmung mit dem Pegel des Eingangssignals $(S_2)$ amplitudenmoduliert ist;

eine Leistungsverstärkerstufe (5 bis 10), die mit dem Ausgangssignal $(S_7)$ des Addiermittels (25) versorgt wird, wobei die Leistungsverstärkerstufe (5 bis 10) ein Paar von bipolaren Transistoren (7, 8) enthält, die zu einer komplementären Gegentaktanordnung zusammengeschaltet sind.

2. Leistungsverstärker nach Anspruch 1, dadurch gekennzeichnet, daß das Paar von Pegelverschiebungsmitteln (21, 22) den Pegel des Eingangssignals $(S_2)$ um vorbestimmte Beträge in positiver bzw. negativer Richtung verschiebt.

3. Leistungsverstärker nach Anspruch 1, dadurch gekennzeichnet, daß desweitern Impulsbreitenmodulationsmittel (2 bis 4) vorgesehen sind, die eine Integrationsschaltung (3) zum Integrieren des Eingangssignals $(S_2)$ in Abhängigkeit von einem Taktsignals $(S_1)$, das durch eine Taktsignalquelle (2) bereitgestellt wird, um ein Sägezahnsignal $(S_3)$ zu erzeugen, und einen Komparator (4) zum Vergleichen des Sägezahnsignals $(S_3)$ mit einer Referenzspannung enthalten, wodurch das impulsbreitenmodulierte Signal $(S_4)$ an dem Ausgang des Komparators (4) erzeugt wird.

4. Leistungsverstärker nach Anspruch 1, 2 oder 3, dadurch gekennzeichnet, daß ein weiteres Paar von Transistoren (5, 6) in der Leistungsverstärkerstufe (5 bis 10) vorgesehen ist, die zu einer Anordnung zusammengeschaltet sind, in der die Emitter jeweils geerdet sind.

## Revendications

1. Amplificateur de puissance destiné à fournir un signal modulé par impulsions de largeur variable proportionnel à l'amplitude d'un signal d'entrée $(S_2)$, caractérisé en ce qu'il comprend:

une paire de dispositifs changeurs de niveau (21, 22), à chacun desquels est appliqué le signal d'entrée $(S_2)$;

une paire de dispositifs de commutation (23, 24) commandés par un signal molulé par impulsions de largeur variable ($S_4$) dérivé du signal d'entrée ($S_2$) pour transmettre des signaux de sortie ($S_5$, $S_6$) des dispositifs changeurs de niveau (21, 22);

un dispositif de sommation (25) pour combiner les signaux de sortie des dispositifs de commutation (23, 24) afin de produire un signal modulé par impulsions de largeur variable ($S_7$) qui est modulé en amplitude selon le niveau du signal d'entrée ($S_2$); et

un étage amplificateur de puissance (5 à 10), auquel est appliqué le signal de sortie ($S_7$) du dispositif de sommation (25), cet étage amplificateur de puissance (5 à 10) comprenant une paire de transistors bipolaires (7, 8) dans un montage symétrique complémentaire.

2. Amplificateur de puissance selon la revendication 1, où la paire de dispositifs changeurs de niveau (21, 22) change le niveau du signal d'entrée ($S_2$) de quantités prédéterminées dans le sens positif respectivement dans le sens négatif.

3. Amplificateur de puissance selon la revendication 1, comprenant en outre un dispositif (2 à 4) de modulation par variation de largeur d'impulsions, qui est constitué d'un circuit d'intégration (3) pour intégrer le signal d'entrée ($S_2$) en fonction d'un signal d'horloge ($S_1$) fourni par une source de signal d'horloge (2), en vue de la production d'un signal ($S_3$) en dents de scie, et d'un comparateur (4) pour comparer le signal ($S_3$) en dents de scie avec une tension de référence, de sorte que le signal modulé par impulsions de largeur variable ($S_4$) est produit à la sortie du comparateur (4).

4. Amplificateur de puissance selon la revendication 1, 2 ou 3, où une autre paire de transistors (5, 6) est prévue dans l'étage amplificateur de puissance (5 à 10) dans un montage avec émetteur à la masse.

# F I G. 1

0 058 724

F I G. 2

F I G. 7

F I G. 4

F I G. 8

2

FIG. 3A

$I_{B7}$

FIG. 3B

$I_{B8}$

FIG. 3C

$I_{C7}$  $I_{C8}$

FIG. 6A

$S_1$

FIG. 6B

$S_2$

0

FIG. 6C

$S_3$

0

FIG. 6D

$S_4$

0

FIG. 6E

$S_5$  $S_7$

0

$S_6$

F I G. 5